Europäisches Patentamt

(19) European Patent Office

Office européen des brevets

(11) Numéro de publication : **0 337 908 B1**

(12) # FASCICULE DE BREVET EUROPEEN

(45) Date de publication du fascicule du brevet :
**21.11.91 Bulletin 91/47**

(51) Int. Cl.$^5$ : **G01R 33/30**

(21) Numéro de dépôt : **89440018.3**

(22) Date de dépôt : **28.02.89**

(54) **Sonde pour mesures spectrométriques de résonances magnétiques aux très hautes températures.**

(30) Priorité : **01.03.88 FR 8802740**

(43) Date de publication de la demande :
**18.10.89 Bulletin 89/42**

(45) Mention de la délivrance du brevet :
**21.11.91 Bulletin 91/47**

(84) Etats contractants désignés :
**CH DE ES GB IT LI NL SE**

(56) Documents cités :
**EP-A- 0 020 085**
**DD-A- 243 768**
**US-A- 3 588 677**
**US-A- 4 305 036**
**REVIEW OF SCIENTIFIC INSTRUMENTS vol.
51, n 4, avril 1980, pages 464-466, New York,
US, T.A. YAGER et al.:"Laser-heated hightemperature EPR spectroscopy"**
**SOVIET INVENTIONS ILLUSTRATED semaine
E 19, 23 juin 1982, résumé n 39057, LO3 SO3,
Derwent Publications Ltd., Londres, GB; & SU
A 851217**

(73) Titulaire : **SADIS BRUKER SPECTROSPIN, S.A.
34, rue de l'Industrie
F-67160 Wissembourg (FR)**

(72) Inventeur : **Brevard, Christian
38, rue de la Pépinière
F-67160 Wissembourg (FR)**
Inventeur : **Coutures, Jean-Pierre
CNRS 1 D, avenue de la Recherche
Scientifique
F-45071 Orléans Cedex 2 (FR)**
Inventeur : **Massiot, Dominique
66, Quai du Châtelet
F-45000 Orléans (FR)**
Inventeur : **Rifflet, Jean-Claude
9 bis, rue Tudelle
F-45100 Orléans (FR)**
Inventeur : **Taulelle, Francis
65, Boulevard du Mal Joffre
F-92340 Bourg-la-Reine (FR)**

(74) Mandataire : **Metz, Paul
CABINET METZ PATNI 63, rue de la Ganzau
B.P. 63
F-67024 Strasbourg (FR)**

## Description

La présente invention se rapporte à une sonde perfectionnée pour mesures spectrométriques de résonances magnétiques aux très hautes températures telles que celles pratiquées avec des résonateurs utilisés en résonance magnétique nucléaire ou en résonance paramagnétique électronique.

La transmission d'énergie au système de spins nucléaires que représente l'échantillon de matière pendant la période d'excitation s'effectue par l'intermédiaire de la sonde qui porte ledit échantillon.

La récupération d'énergie émise par le système de spins retournant à l'équilibre s'effectue également par la sonde.

Celle-ci constitue la partie essentielle d'un résonateur. C'est à travers elle que s'effectue la mesure spectrométrique de la résonance.

La sonde se compose d'une partie mécanique porte-échantillon et du circuit électronique à réseau d'antenne formant le résonateur radio ou hyper-fréquences proprement dit. Ce réseau crée une onde électromagnétique située dans la gamme des radio ou hyper fréquences, concentrée dans le volume contenant l'échantillon.

Pour réaliser une mesure de spectrométrie de résonance aux très hautes températures à l'aide d'un résonateur utilisé en résonance magnétique, deux conditions essentielles sont à remplir simultanément:

- l'échantillon doit être contenu dans le volume d'irradiation en ondes radio ou hyper-fréquences,
- l'échantillon doit être chauffé dans le même volume d'irradiation pour permettre les mesures aux températures voulues.

On procède actuellement par le chauffage de l'échantillon à l'aide d'un flux d'air thermostaté traversant la chambre du résonateur renfermant le support porte-échantillon.

La régulation de température s'effectue sur une valeur de consigne, par exemple +100°C, affichée sur le coffret de régulation et maintenue dans la chambre de mesure à l'aide d'une boucle de régulation, par exemple à thermocouple.

Pour des températures de mesure comprises entre 200 et 600°C, on utilise actuellement en mesures de résonances magnétiques une sonde spéciale blindée, dont le refroidissement est assuré par un ensemble pompe et fluide calo-extracteur (en général de l'huile).

Ce type de refroidissement nécessaire à la protection du résonateur engendre une plus-value importante sur le coût total de la sonde de mesure.

L'émission en ondes radio ou hyper-fréquences de l'échantillon est détectée par un capteur sensible dans la bande des radio ou hyper-fréquences étudiées.

Classiquement, ce capteur est en contact direct avec l'échantillon.

Echantillon et capteur étant nécessairement solidaires, l'augmentation de la température de l'échantillon se traduit par une augmentation corrélative du bruit thermique du capteur qui arrive à masquer le signal à mesurer.

Par ailleurs, toute isolation thermique par enrobage ou autre ne peut convenir, en raison, pour l'enrobage, de ses difficultés à maintenir la température et, pour divers autres types d'isolations thermiques, du caractère d'écran qu'elles représentent pour les ondes radio ou hyper-fréquences et des signaux perturbateurs qu'elles peuvent générer.

La deuxième condition importante pour que la mesure ait un sens, est de ne pas altérer l'échantillon et éviter toute réaction chimique avec le récipient qui le contient.

En effet, les échantillons chauffés présentent des caractéristiques physiques et chimiques propres qui peuvent modifier les caractéristiques du capteur par réaction avec le support porte-échantillon.

De ce fait, ces augmentations de température risquent d'induire des réactions chimiques par interaction avec le support au sein de l'échantillon dont la nature se modifie et fausse ainsi notablement les mesures.

Finalement, une élévation notable des températures de mesure se propage au résonateur par dissipation thermique et modifie ainsi de façon importante ses caractéristiques de fonctionnement. L'état de la technique est montré dans l'Article de Yaper et al., Review of Scientific Instruments vol. 51 no. 4 (1980) pages 464-466 et EP-A-20085.

L'invention a pour but de réaliser une indépendance totale entre l'échantillon et le capteur tout en maintenant l'échantillon dans le volume d' irradiation pendant le chauffage dans des conditions permettant la réalisation de températures très élevées pour les mesures visées comprises entre 800 et 2.500°C.

La présente invention permet de s'affranchir des multiples contraintes technologiques liées à l'augmentation notable de température souhaitable pour l'observation du comportement de certains matériaux à haute tenue en température tels que les matériaux réfractaires, céramiques et autres, soit à l'état solide ou à l'état liquide.

A cet effet, elle se rapporte à une sonde pour résonateur de spectrométrie pour très hautes températures caractérisée en ce que l'on utilise conjointement comme moyen de chauffage la concentration sur l'échantillon d'un rayonnement laser et comme moyen de découplage la lévitation de l'échantillon dans le volume intérieur du résonateur.

De nombreux avantages sont procurés par la présente invention, tels que :

- l'indépendance totale entre le résonateur et l'échantillon permettant des mesures à très haute température dans la gamme 800-2.500°C ;
- la possibilité de substituer ce type de sonde à celui existant actuellement par de simples modifications se limitant à des adaptations d'ordre mineur ;

● la garantie que les caractéristiques de la sonde et celles de fonctionnement de l'ensemble restent sensiblement identiques, quelle que soit la température ;

● simplicité de mise en oeuvre ;

● on atteint facilement des températures élevées sans perte de sensibilité ;

● fort découplage procuré par la lévitation de l'échantillon ;

● dissipation thermique canalisée par le flux de gaz de lévitation et bobine maintenue sous flux d'azote gazeux.

La présente invention sera bien comprise à la lecture de la description qui suit, effectuée à titre d'exemple non limitatif sur un mode d'exécution en spectrométrie de résonances magnétiques nucléaires en référence aux dessins accompagnants dans lesquels :

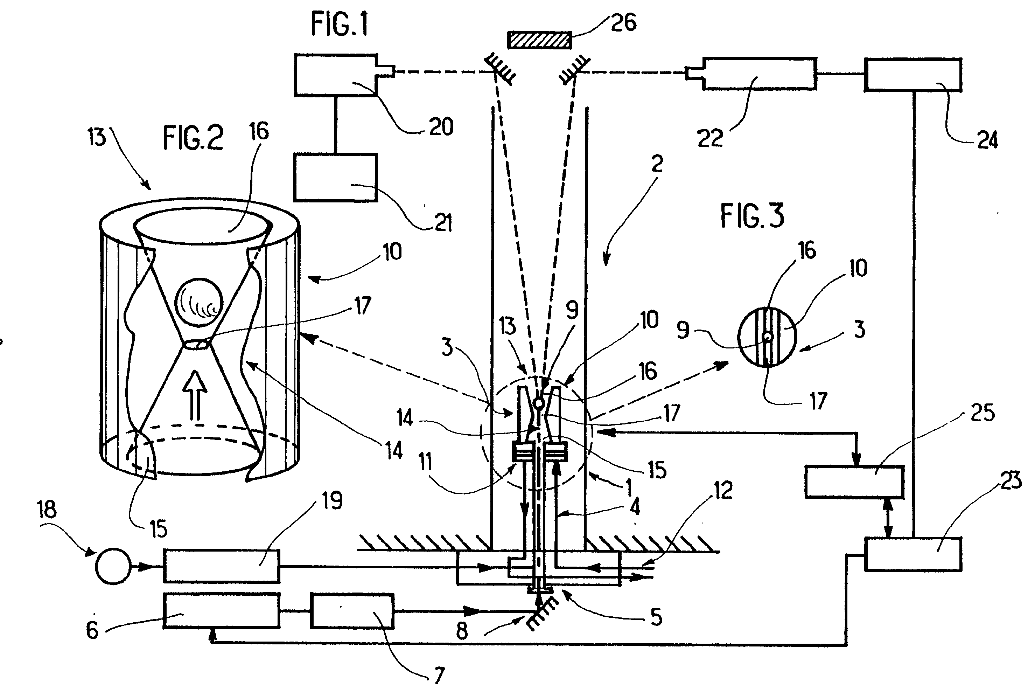

● la figure 1 est le schéma général de la sonde et de son ensemble de mesure et d'analyse ;

● la figure 2 est une vue schématique en perspective du corps du résonateur à lévitation, échantillon en place ;

● la figure 3 est une vue de détail en plan du corps du résonateur à lévitation selon une forme dérivée.

On décrira ci-après les moyens généraux de l'invention ainsi que quelques exemples de moyens particuliers.

Il est bien entendu que tous les moyens équivalents, c'est-à-dire remplissant la même fonction en vue d'obtenir les mêmes résultats conviennent et ressortent de l'invention.

L'idée générale inventive consiste à utiliser conjointement deux moyens principaux pour assurer l'indépendance totale de l'échantillon par rapport à son environnement et le chauffage de celui-ci.

— Il s'agit d'une part de maintenir l'échantillon en constante lévitation au sein du résonateur en utilisant un débit contrôlé d'un gaz de lévitation.

— Il s'agit d'autre part de chauffer l'échantillon à l'aide d'un faisceau de lumière cohérente concentré sur l'échantillon.

Il s'agit de maintenir l'électronique du résonateur sous un flux d'azote gazeux.

On décrira maintenant plus en détail les moyens indiqués ci-dessus dans leur fonction générale.

La sonde selon l'invention comporte un corps de sonde 1 à insérer en lieu et place d'une sonde conventionnelle dans un aimant 2 à bobine supraconductrice. Le corps de sonde renferme un résonateur-lévitateur 3.

Selon l'invention, le résonateur est relié optiquement à l'extérieur par un conduit servant de guide optique 4 recevant à travers un hublot terminal 5 un faisceau de lumière cohérente émise par un laser 6 de longueur d'onde appropriée, faisceau dirigé après concentration éventuelle par un élément optique 7 vers ledit hublot par un miroir de renvoi 8.

Le rayonnement laser traverse le résonateur-lévitateur 3 dans lequel se trouve disposé un échantillon 9 et, grâce à une concentration, permet de chauffer localement la partie centrale du résonateur occupée par ledit échantillon.

A titre d'exemple, on adoptera un laser de longueur d'onde de 1,06 μm pour les métaux et un laser à dioxyde de carbone de 10,6 μm pour les isolants : oxydes, halogènes et autres.

Cette utilisation originale du laser comme mode de chauffage de l'échantillon assure une grande concentration d'énergie dans le volume occupé par l'échantillon et permet une montée importante en température.

Une autre caractéristique originale concerne le moyen de découplage de l'échantillon à analyser selon laquelle le résonateur-lévitateur 3 de la sonde selon l'invention présente un corps creux 10 à surface latérale fermée en cuivre ou tout autre métal ou matière amagnétique convenable, de forme générale extérieure cylindrique, monté sur une embase métallique 11 refroidie par un circuit 12 d'azote évaporé.

Les pièces du résonateur-lévitateur 3 constituent l'antenne radio-fréquences 13. Elles présentent, dans le mode de réalisation préféré, une conformation intérieure en bicône 14 formant un double ajutage convergent puis divergent. Cet ajutage délimite un volume intérieur libre à cavité conique convergente, inférieure 15 puis conique divergente supérieure 16, cavités séparées par une zone d'étranglement constituant un passage circulaire 17.

L'échantillon 9 dont le comportement est à mesurer se trouve disposé dans la cavité supérieure 16.

La taille de l'échantillon sera choisie de façon à ne pas pouvoir traverser le passage 17 de la zone d'étranglement entre les deux cavités 15 et 16.

En effet, en absence de force de lévitation l'échantillon se trouve à un point bas et il importe que celui-ci reste dans la cavité supérieure.

Selon l'invention, l'échantillon 9 disposé dans la cavité supérieure 16 est maintenu en lévitation par le flux contrôlé d'un gaz de lévitation 18 introduit par le conduit optique 4 dans lequel se propage le faisceau laser de chauffage.

Le flux de ce gaz est contrôlé par un débitmètre 19 et régulé par un dispositif approprié.

L'effet venturi apporté par la conformation en double ajutage convergent puis divergent améliore sensiblement le pouvoir de lévitation du flux de gaz ainsi que la dissipation thermique.

A titre d'exemple, le volume intérieur en bicône présente une hauteur totale de 20 mm, le demi-angle étant de 60° et le diamètre du passage compris entre 2 et 3,5 mm.

On précise ici que le corps du lévitateur est, par exemple, en cuivre pour le rayonnement laser de longueur d'onde 10,6 μm (laser à gaz carbonique) et en céramique lorsqu'il doit être associé à un laser de longueur d'onde 1,06 μm.

Le débit volumique du gaz de lévitation est compris entre 1 et 1,5 litres par minute.

Avec ces moyens, un régime de lévitation stable pour un échantillon de masse comprise entre 20 et 120 mg peut être maintenu pendant une durée d'environ une heure.

L'antenne radio-fréquences ou le résonateur proprement dit doit être formé par une boucle de courant à comportement selfique.

Pour ce faire, le corps du résonateur-lévitateur 3 est réalisé par un empilement d'une succession de segments alternativement conducteurs puis isolants, par exemple métalliques puis en céramique et de préférence en cuivre puis en céramique.

On accorde et adapte le circuit résonnant ainsi constitué à la ou aux fréquences de travail concernée(s) par l'adjonction des capacités et inductances nécessaires.

Divers matériels et appareils de mesure et d'observation entourent la sonde, tels que caméra 20 et moniteur vidéo 21 pour l'observation de l'échantillon en lévitation et un pyromètre 22 relié à un calculateur 23 par une détection synchrone 24. Le calculateur est relié à un spectromètre 25 et sert également à l'asservissement en puissance du laser.

Classiquement, le spectromètre est également relié à l'antenne radio-fréquences constituant le corps du résonateur-lévitateur car selon le principe général de la mesure, l'antenne sert également de capteur.

Pour des raisons de protection, on prévoit, en sortie de sonde, un obturateur 26 en matériau absorbant pour le rayonnement laser utilisé, par exemple en céramique.

La mesure de la température de l'échantillon s'effectue par pyrométrie optique dans la gamme des 2 à 10 μm et dans le domaine dans lequel le matériau utilisé ne transmet pas et présente un facteur d'émission proche de l'unité.

Une forme de réalisation dérivée du corps du résonateur est représentée sur la figure 3. Selon cette variante, les cavités inférieure 15 et supérieure 16 affectent une forme générale prismatique et le passage 17 est une simple fente rectangulaire.

Bien entendu, les cavités sont fermées latéralement pour permettre au flux du gaz d'exercer son effet de lévitation.

## Revendications

1. Sonde pour mesures spectrométriques de résonances magnétiques aux très hautes températures comportant un résonateur (3) à corps creux contenant un échantillon (9) à analyser, caractérisée en ce que l'on utilise conjointement comme moyen de chauffage de l'échantillon (9) un faisceau de lumière cohérente et comme moyen de découplage dudit échantillon (9) par rapport à son environnement, la lévitation au sein du volume intérieur du résonateur.

2. Sonde selon la revendication 1, caractérisée en ce que le résonateur est en même temps le lévitateur.

3. Sonde selon les revendications 1 et 2, caractérisée en ce que la lévitation est réalisée au moyen d'un flux de gaz à débit contrôlé et régulé, traversant longitudinalement le corps du résonateur (3).

4. Sonde selon les revendications 1, 2 et 3, caractérisée en ce que le corps du résonateur (3) est délimité par une surface latérale à paroi continue reliant deux cavités superposées.

5. Sonde selon la revendication 4, caractérisée en ce que les cavités sont d'une part une cavité inférieure (15) et d'autre part une cavité supérieure (16) respectivement convergente et divergente vers le haut, séparées par une zone d'étranglement formant un passage (17).

6. Sonde selon les revendications 4 et 5, caractérisée en ce que l'échantillon est de taille supérieure à la section du passage (17).

7. Sonde selon les revendications précédentes, caractérisée en ce que le corps du résonateur (3) est formé par un empilement d'une succession de segments alternativement conducteurs puis isolants.

8. Sonde selon la revendication 7, caractérisée en ce que la succession de segments est une succession alternative de segments en cuivre puis en céramique.

9. Sonde selon les revendications précédentes, caractérisée en ce que le corps du résonateur (3) repose sur une embase métallique (11) refroidie par un circuit réfrigérant contenant un gaz.

10. Sonde selon les revendications précédentes, caractérisée en ce que le rayonnement laser est introduit dans la sonde et le corps du résonateur (3) par un guide optique (4).

11. Sonde selon les revendications précédentes, caractérisée en ce qu'elle est obturée par un écran absorbant au rayonnement laser.

## Patentansprüche

1. Sonde für spektrometrische Messungen von magnetischen Resonanzen bei sehr hohen Temperaturen, die einen Resonator (3) mit hohlem Körper aufweist, der eine zu untersuchende Probe (9) enthält, **dadurch gekennzeichnet,** daß man gleichzeitig als Einrichtung zum Erwärmen der Proben (9) einen kohärenten Lichtstrahl benutzt und als Mittel zum Trennen dieser Probe (9) in Bezug auf ihre Umgebung das Schweben im Innenraum des Resonators.

2. Sonde nach Anspruch 1, **dadurch gekennzeichnet**, daß der Resonator gleichzeitig das Mittel zum Erzeugen des Schwebens ist.

3. Sonde nach den Ansprüchen 1 und 2, **dadurch gekennzeichnet**, daß man das Schweben mittels eines, den Resonatorkörper (3) in Längsrichtung durchströmendenden, geregelten Gasstromes mit kontrollierter Durchsatzmenge bewirkt.

4. Sonde nach den Ansprüchen 1, 2 und 3, **dadurch gekennzeichnet**, daß der Körper des Resonators (3) durch eine seitliche Fläche mit kontinuierlicher Wand begrenzt ist, die zwei übereinanderliegende Hohlräume mit kontinuierlicher Wand verbindet.

5. Sonde nach Anspruch 4, **dadurch gekennzeichnet**, daß die Hohlräume einerseits ein unterer Hohlraum (15) und andererseits ein oberer Hohlraum (16) sind, die entsprechend nach oben konvergieren bzw. divergieren und die durch einen Einschnürungsbereich getrennt sind, der einen Durchgang (17) bildet.

6. Sonde nach den Ansprüchen 4 und 5, **dadurch gekennzeichnet**, daß die Probe größer ist als der Querschnitt des Durchgangs (17).

7. Sonde nach den vorhergehenden Ansprüchen, **dadurch gekennzeichnet**, daß sich der Resonatorkörper (3) aus einem Stapel von aufeinanderfolgenden Segmenten zusammensetzt, die abwechselnd leitend bzw. isolierend sind.

8. Sonde nach Anspruch 7, **dadurch gekennzeichnet**, daß die Folge von Segmenten eine abwechselnde Folge von Segmenten aus Kupfer bzw. aus Keramik ist.

9. Sonde nach den vorhergehenden Ansprüchen, **dadurch gekennzeichnet**, daß der Resonatorkörper (3) auf einem metallischen Sockel (11) ruht, der durch einen, ein Gas enthaltenden Kühlkreislauf gekühlt ist.

10. Sonde nach den vorhergehenden Ansprüchen, **dadurch gekennzeichnet**, daß man die Laserstrahlung in die Sonde und den Resonatorkörper (3) über ein optische Führung (4) einleitet.

11. Sonde nach den vorhergehenden Ansprüchen, **dadurch gekennzeichnet**, daß sie mit einer Blende verschlossen ist, welche die Laserstrahlung absorbiert.

## Claims

1. Probe for spectrometric measurements of magnetic resonances at very high temperatures, comprising a resonator (3) having a hollow body containing a sample (9) to be analysed, characterised in that there is used jointly as a means of heating the sample (9) a beam of coherent light and as a means of decoupling the said sample (9) in relation to its surroundings, levitation within the internal volume of the resonator.

2. Probe according to claim 1, characterised in that the resonator is at the same time the levitator.

3. Probe according to claims 1 and 2, characterised in that levitation is produced by means of a flow of gas at a controlled and regulated rate passing longitudinally through the body of the resonator (3).

4. Probe according to claims 1, 2 and 3, characterised in that the body of the resonator (3) is delimited by a lateral surface having a continuous wall connecting two superimposed cavities.

5. Probe according to claim 4, characterised in that the cavities are on the one hand a lower cavity (15) and on the other hand an upper cavity (16) respectively converging and diverging upwards, separated by a zone of contraction forming a passage (17).

6. Probe according to claims 4 and 5, characterised in that the sample is larger in size than the section of the passage (17).

7. Probe according to the preceding claims, characterised in that the body of the resonator (3) is formed by a stacking of a succession of alternately conductive and insulating segments.

8. Probe according to claim 7, characterised in that the succession of segments is an alternating succession of segments made of copper and ceramics.

9. Probe according to the preceding claims, characterised in that the body of the resonator (3) rests on a metal seating (11) cooled by a cooling circuit containing a gas.

10. Probe according to the preceding claims, characterised in that laser radiation is introduced into the probe and the body of the resonator (3) by an optical guide (4).

11. Probe according to the preceding claims, characterised in that it is closed by a laser radiation-absorbing screen.

FIG.1

FIG.2

FIG.3

EP 0 337 908 B1